# EUROPEAN PATENT APPLICATION

(11) **EP 1 075 169 A1**
(43) Date of publication of application: **07.02.2001**
(21) Application number: 00114270.2
(22) Date of filing: 04.07.2000
(51) Int. Cl.: H05K 1/00

(54) **Method for producing components with electrical conductor tracks arranged in them and components produced by this method, in particular as door modules for motor vehicles**

(30) Priority: 07.07.1999 DE 19931189
(71) Applicant: Meritor Automotive GmbH, 60314 Frankfurt (DE)
(72) Inventor: Drewniok, Daniel, 60314 Frankfurt (DE); Schroeder, Andreas, 55278 Mommensheim (DE)
(74) Representative: Beil, Hans Christoph, Dr.

(57) **Abstract**

Method of producing components with electrical conductor tracks arranged in them, in which method a substrate material provided with these conductor tracks and the plug-in connectors connected with them and lying with their outer terminal area in the surface of the component is placed into a component mould and the mould is then filled with foamed plastic. The components are used in particular as door modules in vehicle construction.

## Description

The subject-matter of the invention is a method having the generic features of Claim 1.

In motor vehicle construction as well as in numerous other fields of application, components with corresponding cable harnesses must be arranged on a mounting plate, and fastened there by a wide variety of methods, before they are finally fitted. The mounting plate often consists of metal and offers only few possibilities of integrating the required components. In vehicle construction, problems arise in this respect particularly with the door modules, in which inadequate fastening of the cable harnesses leads to rattling and the fitting of the various components requires considerable installation times.

The invention is based on the object of providing a component in which on the one hand the required electrical conductor tracks are reliably laid and which on the other hand allows additional components or moulded parts to be easily integrated. Furthermore, the laid conductor tracks are to be optionally protected from physical effects, such as centrifugal forces, vibration or moisture.

This object is achieved by the features defined in the characterizing clause of Claim 1. According to the latter, the substrate material which is provided with the required conductor tracks and the plug-in connectors connected with them and which preferably consists of plastic is placed into a mould for the component concerned and then filled with foamed plastic. Further moulded parts or components and/or electrical or electronic components connected to the conductor tracks may be arranged on the substrate material before foam filling. The finished component then contains all the required constituent components, which can be connected to other components of the overall device via the externally accessible plug-in connectors.

The conductor tracks may be individual cables or stranded wires, round or flat ribbon conductors or cable harnesses. These are preferably fixed before introducing the foam by using a thermoformed film of plastic in which the routing of the individual lines is predetermined in the form of a corresponding depression. However, a film of plastic on which the corresponding conductor tracks are stamped may also be used. The substrate material with the conductor tracks and the other components or moulded parts is placed into the outer mould of the mould defining the component and the mould is then filled with a suitable foamed plastic material. Both thermoplastic and thermosetting resins, preferably reinforced with glass fibres, may be considered for this.

The plug-in connectors, with their terminal side exposed in the component, are protected against the penetration of foam before foam filling by suitable coverings, which can easily be removed after foam filling. Depending on the design of these connectors, a wide variety of solutions for this are available to a person skilled in the art.

To explain the invention, a special form of component that can be produced according to the invention is described in more detail with reference to the attached drawings, in which:
Figure 1 shows a perspective view of a door module for the side doors of a passenger car and
Figure 2 shows a perspective sectional view of the design with a plug-in connector.

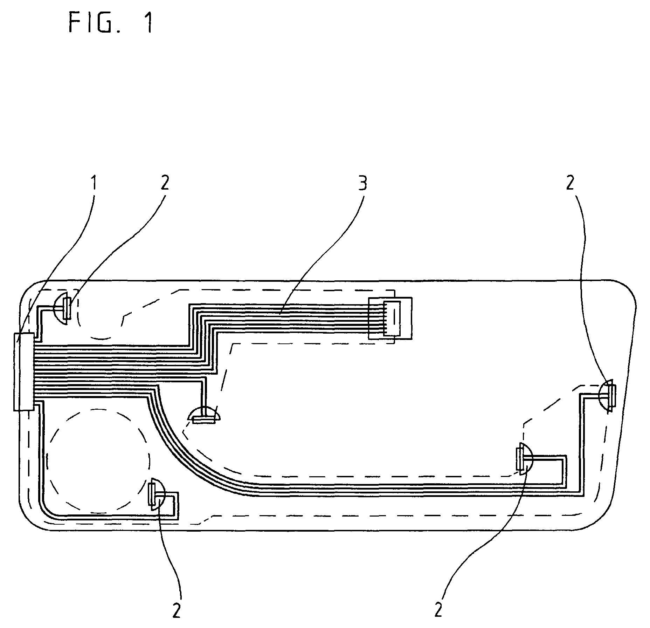

Shown in Figure 1 is a door module which is to be fitted into the side doors of a passenger car and has on the one hand an input plug-in connection (1) for supplying the module with the electric power required for the individual components (not shown), such as window lifters, door lighting or loudspeakers for example. From this plug-in connection, the lines (3) extend on the mounting plate to the individual end plug-in connections (2), which permit the connection of the end loads.

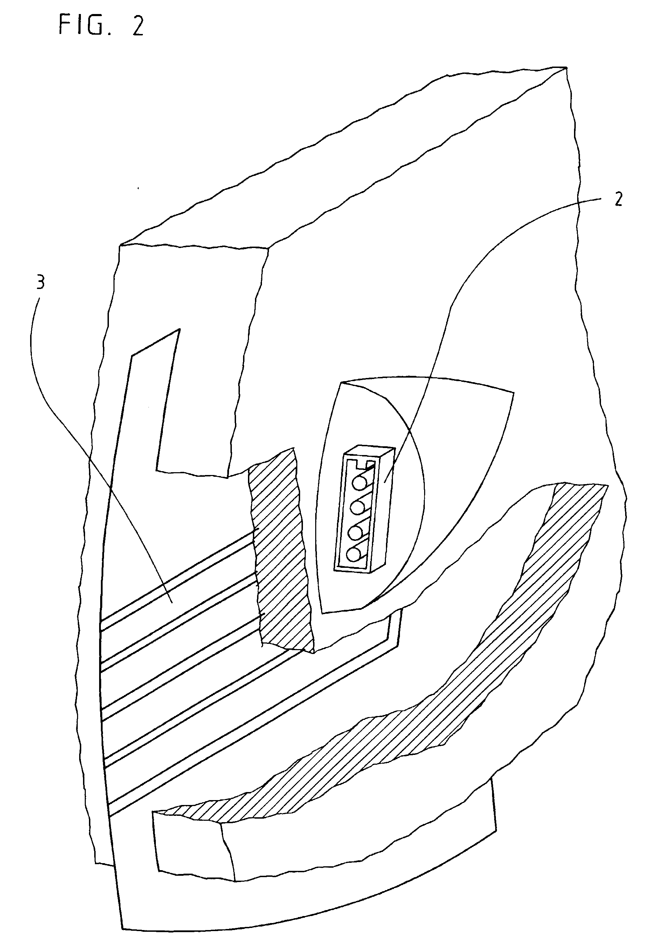

Figure 2 shows the detail of such an end plug-in connection (2). The mounting plate with the conductor tracks attached on it is in this case surrounded on both sides by foamed plastic, but the invention also comprises the design in which this mounting plate represents the rear side of the component. The end plug-in connector (2) lies with the side which is intended for the connection of the end load in the surface of the component, which in this case has a hollow, and permits the introduction of the attachment plug (not shown) parallel to the shown front surface of the component. Any other design, such as for example the forming of a depression in front of the plug-in connector or a flat termination of the plug-in connectors with the planar surface of the component, is likewise within the scope of the present invention.

The method according to the invention and the components produced with it represent a very economical solution, because it is possible for the component to be largely prefabricated with all the components required; installation work is consequently reduced significantly and at the same time a considerable weight saving can be achieved in comparison with designs previously customary in vehicle construction.

## Claims

1. Method of producing components with electrical conductor tracks arranged in them, characterized in that a substrate material provided with these conductor tracks (3) and the plug-in connectors (1, 2) connected with them and lying with their outer terminal area in the surface of the component is placed into a component mould and the mould is then filled with foamed plastic.

2. Method according to Claim 1, characterized in that the substrate material consists of plastic.

3. Method according to Claim 1 or 2, characterized in that the conductor tracks (3) with the plug-in connectors (1, 2) are placed in a thermoformed film of plastic which predetermines the routing of the lines.

4. Method according to Claim 3, characterized in that the conductor tracks are individual cables or cable harnesses, stranded wires or round or flat ribbon conductors.

5. Method according to Claim 1 or 2, characterized in that the conductor tracks (3) are stamped on the substrate.

6. Method according to one of Claims 1 to 5, characterized in that additional electrical and/or electronic components are connected to the conductor tracks and arranged with the latter on the substrate material.

7. Method according to one of Claims 1 to 6, characterized in that additional moulded parts or components are arranged on the substrate material.

8. Method according to one of Claims 1 to 7, characterized in that thermoplastic resins are used for the foam filling.

9. Method according to one of Claims 1 to 7, characterized in that thermosetting resins are used for the foam filling.

10. Method according to Claim 8 or 9, characterized in that glass-fibre-reinforced plastics are used.

11. Components with electrical conductor tracks arranged in them, produced by the method of one of Claims 1 to 10.

12. Door modules for motor vehicles, in particular passenger cars, comprising components according to Claim 11.
